# EUROPEAN PATENT APPLICATION

(11) **EP 4 557 362 A2**
(43) Date of publication of application: **21.05.2025**
(21) Application number: 24208626.2
(22) Date of filing: 24.10.2024
(51) Int. Cl.: H01L 23/482, H01L 25/07, H01L 23/31, H01L 23/495

(54) **MULTI-DIE POWER SEMICONDUCTOR PACKAGE**

(30) Priority: 30.10.2023 US 202318497669
(71) Applicant: Infineon Technologies Canada Inc., Kanata, Ontario K2V 1C8 (CA)
(72) Inventor: ZUNIGA, Marco A., Kanata, K2V 1C8 (CA); MICHAEL, Mihalis, Kanata, K2V 1C8 (CA); MACELWEE, Thomas William, Kanata, K2V 1C8 (CA); UNNI, Vineet, Kanata, K2V 1C8 (CA); DIXIT, Abhinandan Hemant, Kanata, K2V 1C8 (CA); ZAMIL, Mohammad Shafayet, Kanata, K2V 1C8 (CA); NAJAFI, Farzin, Kanata, K2V 1C8 (CA)
(74) Representative: Kraus & Lederer PartGmbB

(57) **Abstract**

A package for multiple integrated circuit dies (e.g., chips). Various common couplers are layered between the chips and package contacts of the package. Each of the chips has a planar surface (e.g., a flat top surface) along which the chips include die contacts. The common couplers lie along the planar surface of each of the chips, and electrically connects the die contacts of the chips to the package contacts of the package. This allows the chips, the common couplers, and the package contacts to be stacked together to form a relatively thin, compact package. The common couplers connect the die contacts of any particular type to the corresponding package contacts of that particular type, such that the die contacts need not have the same layout as the package contacts, thus allowing packages with the same package contact layouts to be used to package chips with varying die contact layouts.

## Description

### BACKGROUND

An integrated circuit is an electronic circuit that has all of its components manufactured on a common semiconductor substrate by employing semiconductor processing steps. One or more integrated circuits may be incorporated into a package that includes various terminals (e.g., bond pads, pins, or leads). These terminals may be used to, for example, control the integrated circuit, provide power to the integrated circuit, or to allow the integrated circuit to communicate with external components. Packages may provide the integrated circuits with additional physical protection, proper heat dissipation, and mechanical compatibility with external components (e.g., a printed circuit board).

The subject matter claimed herein is not limited to embodiments that solve any disadvantages or that operate only in environments such as those described above. Rather, this background is only provided to illustrate one example technology area where some embodiments described herein may be practiced.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

A package as defined in claim 1 and a method as defined in claim 12 are provided. The dependent claims define further embodiments.

Embodiments described herein relate to a package in which multiple integrated circuit dies (e.g., chips), that perform the same function, are packaged. Each of the integrated circuit dies includes die contacts of various types. For the die contacts of each type, the die contacts of that type from each of the integrated circuit dies are connected together and to a package contact of that same type.

For example, consider a case in which the integrated circuit dies each includes a power field-effect transistor and a sense field-effect transistor, where the gate terminals of the power transistor and the sense transistor are connected together, and the drain terminals of the power transistor and the sense transistor are connected together. Consider further that the source terminals of the power transistor and the sense transistor are not connected together. In this case, each integrated circuit die would contain die contacts of four types; namely, a gate die contact, a drain die contact, a power transistor source die contact, and a sense transistor source die contact. The gate die contacts from all of the integrated circuit dies would be connected together and to a gate package contact. Similarly, the drain die contacts would be connected together and to a drain package contact. In like manner, the power transistor source die contacts would be connected together and to a power transistor source package contact. Finally, the sense transistor source die contacts would be connected together and to a sense transistor source package contact. Each type of die contact is connected to its respective package contact via a respective common coupler that lies between the die contacts and the package contacts, and that are used to electrically connect the die contacts of any particular type to the corresponding package contact of that particular type.

Each of the integrated circuit dies, common couplers, and package contacts are relatively flat, and are stacked on top of each other. For instance, the common couplers may be layered on top of the integrated circuit dies, and the package contacts may be layered on the common couplers. The package may be thin, and relatively compact. Further, the package uses the common couplers to connect (using custom routing) the die contacts of the integrated circuit dies to the package contacts of the package, such that the die contacts of the integrated circuit dies need not have the same layout as the package contacts of the package. Thus, packages having the same package contact layout may be used to package various types of integrated circuit dies having different die contact layouts. Furthermore, because the die contacts of the integrated circuit dies and the package contacts of the package are in close proximity to each other, connected by the relatively thin common couplers, the overall package may be more compact, and may operate with high power density, low on-resistance, and low parasitic inductance.

Additional features and advantages will be set forth in the description which follows, and in part will be obvious from the description, or may be learned by the practice of the teachings herein. Features and advantages of the invention may be realized and obtained by means of the instruments and combinations particularly pointed out in the appended claims. Features of the present invention will become more fully apparent from the following description and appended claims, or may be learned by the practice of the invention as set forth hereinafter.

### BRIEF DESCRIPTION OF THE DRAWINGS

In order to describe the manner in which the advantages and features of the circuits, systems, and methods described herein can be obtained, a more particular description of the embodiments briefly described herein will be rendered by reference to specific embodiments thereof which are illustrated in the appended drawings. Understanding that these drawings depict only typical embodiments of the circuits, systems and methods described herein, and are not therefore to be considered to be limiting of their scope, certain circuits, systems and methods will be described and explained with additional specificity and detail through the use of the accompanying drawings in which:
Figure 1 illustrates a telescopic view of a circuit structure that may be contained within a package in accordance with the principles described herein.
Figure 2 illustrates an integrated circuit, which may be contained within the integrated circuit dies of the circuit structure Figure 1.
Figure 3 illustrates a top view of an example integrated circuit die in which example die contacts are shown.
Figure 4 illustrates a top view of another circuit structure that may be contained within a package in accordance with the principles described herein.
Figure 5 illustrates a package that may contain the circuit structure of Figure 1, in which leads and a portion of a thermal layer protrude or are exposed from outside of the package.
Figure 6 illustrates a flowchart of a method for grouping integrated circuit dies into a package, in accordance with the principles described herein.

### DETAILED DESCRIPTION

Embodiments described herein relate to a package in which multiple integrated circuit dies (e.g., chips), that perform the same function, are packaged. Each of the integrated circuit dies includes die contacts of various types. For the die contacts of each type, the die contacts of that type from each of the integrated circuit dies are connected together and to a package contact of that same type.

For example, consider a case in which the integrated circuit dies each includes a power field-effect transistor and a sense field-effect transistor, where the gate terminals of the power transistor and the sense transistor are connected together, and the drain terminals of the power transistor and the sense transistor are connected together. Consider further that the source terminals of the power transistor and the sense transistor are not connected together. In this case, each integrated circuit die would contain die contacts of four types; namely, a gate die contact, a drain die contact, a power transistor source die contact, and a sense transistor source die contact. The gate die contacts from all of the integrated circuit dies would be connected together and to a gate package contact. Similarly, the drain die contacts would be connected together and to a drain package contact. In like manner, the power transistor source die contacts would be connected together and to a power transistor source package contact. Finally, the sense transistor source die contacts would be connected together and to a sense transistor source package contact. Each type of die contact is connected to its respective package contact via a respective common coupler that lies between the die contacts and the package contacts, and that are used to electrically connect the die contacts of any particular type to the corresponding package contact of that particular type.

Each of the integrated circuit dies, common couplers, and package contacts are relatively flat, and are stacked on top of each other. For instance, the common couplers may be layered on top of the integrated circuit dies, and the package contacts may be layered on the common couplers. The package may be thin, and relatively compact. Further, the package uses the common couplers to connect (using custom routing) the die contacts of the integrated circuit dies to the package contacts of the package, such that the die contacts of the integrated circuit dies need not have the same layout as the package contacts of the package. Thus, packages having the same package contact layout may be used to package various types of integrated circuit dies having different die contact layouts. Furthermore, because the die contacts of the integrated circuit dies and the package contacts of the package are in close proximity to each other, connected by the relatively thin common couplers, the overall package may be more compact, and may operate with high power density, low on-resistance, and low parasitic inductance.

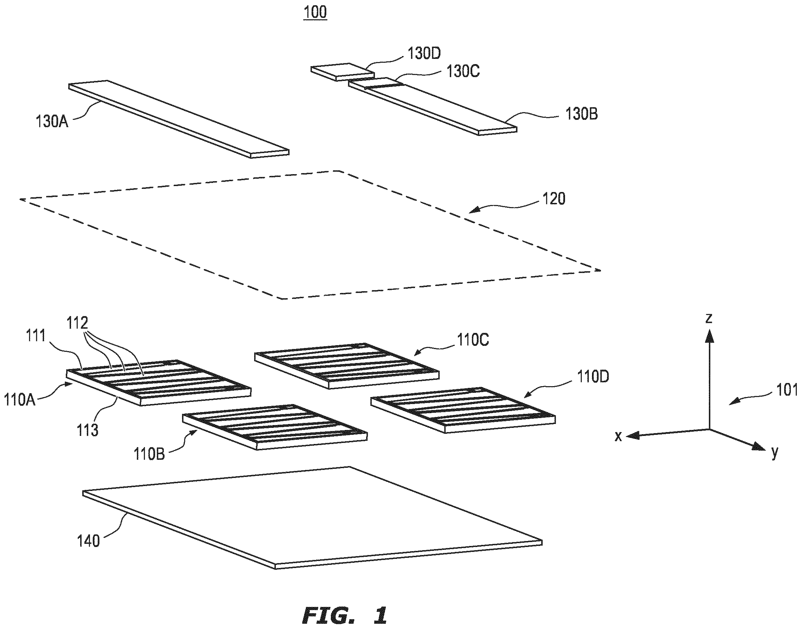

Figure 1 illustrates a telescopic view of a circuit structure 100 that may be contained within a package in accordance with the principles described herein. Figure 1 illustrates a coordinate system 101. For convenience and clarity of explanation only, the z-axis of the coordinate system 101 is referred to as vertical, whereas the x-axis and y-axis are referred to as horizontal. Thus, the plane defined by the x-axis and y-axis is horizontal and is referred to herein as the x-y plane. Directions represented by the arrowhead in the x-axis, y-axis and z-axis will be referred to as the positive x-direction, positive y-direction, and positive z-direction, respectively. On the other hand, the direction opposite the positive x-direction, positive y-direction, and positive z-direction will be referred to as the negative x-direction, negative y-direction, and negative z-direction, respectively. That said, this nomenclature is merely for purposes of clarity. The principles described herein are of course not limited to how an actual circuit structure or package is oriented in the real world.

The circuit structure 100 includes four integrated circuit dies 110A through 110D (referred to collectively as "integrated circuit dies 110"), a common coupler layer 120, and four package contacts 130A through 130D (referred to collectively as "package contacts 130"), stacked on each other in the z-direction. That is, the common coupler layer 120 is stacked on top of the layer of integrated circuit dies 110, and the layer of package contacts 130 is stacked on top of the common coupler layer 120. For clarity, the telescopic view of Figure 1 is presented as it allows for easier distinction between the components of the circuit structure 100, and better representation of the horizontal alignment of the components.

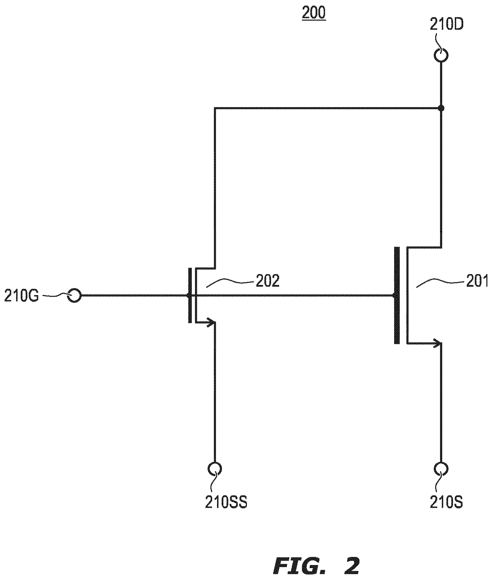

The integrated circuit dies 110 each include a top planar surface 111 that extends parallel to the x-y plane. The integrated circuit dies 110 also each include various die contacts 112 that also extend parallel to the planar surface 111 of each of the integrated circuit dies 110. For purposes of simplicity, in Figure 1, only the integrated circuit die 110A has its planar surface 111 labelled. Furthermore, only the integrated circuit die 110A has some of the die contacts 112 labelled. Each of the other integrated circuit dies 110B through 110D similarly have a top surface and die contacts, though not labelled. Each of the top planar surfaces 111 of the integrated circuit dies 110 are substantially co-planar with each other. In any case, a close-up view of an example integrated circuit die 110 will be discussed later with respect to Figure 2.

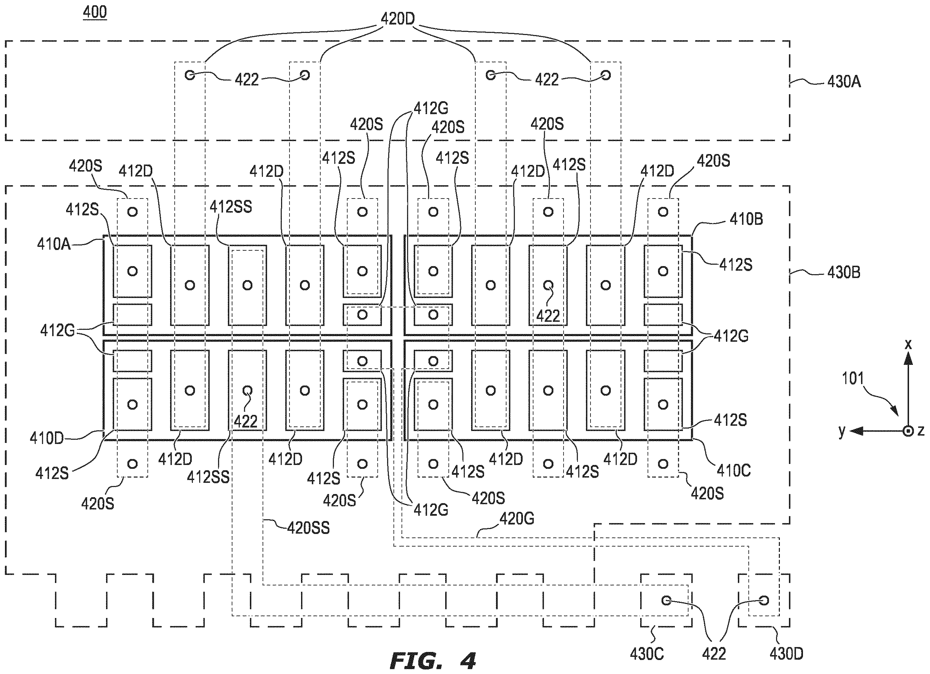

The die contacts 112 of the integrated circuit dies 110 are exposed at the planar surfaces 111 so that the common coupler layer 120 may make contact with the die contacts 112. For purposes of explanation, the common coupler layer 120 is illustrated in Figure 1 as a dashed-line box. A specific example of a common coupler layer will be illustrated and discussed later in greater detail with respect to Figure 4, albeit with a different layout of die contacts and package contacts.

The die contacts 112 may, for example, make electrical contact with an integrated circuit contained within the integrated circuit dies 110. As a specific example only, suppose that each of the integrated circuit dies 110 contains an integrated circuit such as the integrated circuit 200 of Figure 2, although the principles described herein are not limited to the integrated circuit contained within the integrated circuit dies 110. The integrated circuit 200 includes a power transistor 201 and a sense transistor 202, each being field-effect transistors. A gate die contact 210G connects the gate terminals of the transistors 201 and 202, and a drain die contact 210D connects the drain terminals of the transistors 201 and 202. However, the power transistor source die contact 210S is connected to the source terminal of the power transistor 201, and a separate sense transistor source die contact 210SS is connected to the source terminal of the sense transistor 202. The integrated circuit 200 allows for detection of various parameters of the power transistor 201 by monitoring the source of the sense transistor 202.

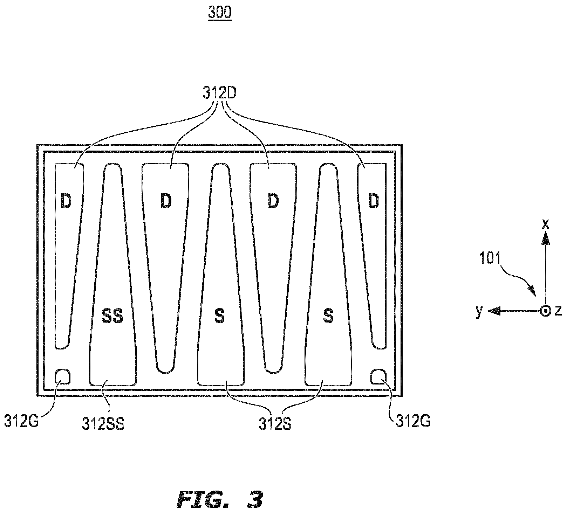

Now, suppose that each of the integrated circuit dies 110 of Figure 1 includes an instance of the integrated circuit 200. In this case, the die contacts 112 would connect to respective terminals of the power transistor 201 and the sense transistor 202. For instance, Figure 3 illustrates a top view of an example integrated circuit die 300 that includes die contacts 312 of various types that may connect to terminals of the power transistor 201 and the sense transistor 202 of Figure 2. Figure 3 likewise also illustrates the coordinate system 101 of Figure 1, but with the positive z-direction directed out of the page, and with the x-y plane being parallel to the plane of the page. Thus, Figure 3 shows an example of an integrated circuit die 300 as viewed by the top, so that the layout of each die contacts 312 may be more easily seen.

Specifically, the integrated circuit die 300 includes gate die contacts 312G that collectively act as the gate die contact 210G, and thus are electrically connected to the common gate terminals of the power transistor 201 and sense transistor 202. Furthermore, the integrated circuit die 300 includes drain die contacts 312D that collectively act as the drain die contact 210D, and thus are electrically connected to the common drain terminals of the power transistor 201 and sense transistor 202. In addition, the integrated circuit die 300 includes power transistor source die contacts 312S that collectively act as the power transistor source die contact 210S, and thus are electrically connected to the source terminal of the power transistor 201. Finally, the integrated circuit die 300 includes a sense transistor source die contact 312SS that acts as the sense transistor source die contact 210SS, and thus is electrically connected to the source terminal of the sense transistor 202.

Referring back to Figure 1, in the case of each of the integrated circuit dies 110 being structured as the integrated circuit die 300 of Figure 3, the package contacts 130 could include a drain package contact 130A, a power transistor source package contact 130B, a sense transistor source package contact 130C, and a gate package contact 130D. Further, in case, the common coupler layer 120 would include a drain common coupler that electrically connects the drain die contacts 312D of each of the integrated circuit dies 110 to the drain package contact 130A. In addition, the common coupler layer 120 would include a power transistor source common coupler that electrically connects the power transistor source die contacts 312S of each of the integrated circuit dies 110 to the power transistor source package contact 130B. Also, the common coupler layer 120 would include a sense transistor source common coupler that electrically connects the sense transistor source die contacts 312SS of each of the integrated circuit dies 110 to the sense transistor source package contact 130C. Finally, the common coupler layer 120 would include a gate common coupler that electrically connects the gate die contacts 312G of each of the integrated circuit dies 110 to the gate package contact 130D.

Accordingly, appropriate voltages may be applied to the terminals of the power transistors 201 and sense transistors 202 contained within the integrated circuit dies 110 via electrical paths that include the package contacts 130, the common coupler layer 120, and the die contacts 112. A specific example of how a common coupler layer may be structured to achieve electrical routing between die contacts and package contacts that is customized to a particular layout of the die contacts and the package contacts, in one very specific and non-limiting example, will be described in detail further below with respect to Figure 4.

Each of the integrated circuit dies 110 of Figure 1 further includes a second planar surface 113 (e.g., a bottom planar surface) on the opposite side of each integrated circuit die 110 as the first planar surface 111. Similar to each of the first planar surfaces 111 of the integrated circuit dies 110, each of the second planar surfaces 113 extends parallel to the x-y plane, and are each substantially co-planar with each other. Also, for purposes of simplicity, in Figure 1, only the integrated circuit die 110A has its second planar surface 113 labelled. The circuit structure 100 further includes a thermal layer 140 that is connected to each of the second planar surfaces 113 of the integrated circuit dies 110.

When the circuit structure 100 is packaged by being encased in an encapsulating component (not shown in Figure 1), a portion of the thermal layer 140 may remain exposed from outside of the encapsulating component and connected to a heatsink. Accordingly, heat may be transferred from the integrated circuit dies 110 to the heatsink via this thermal layer 140. Thus, while a package that contains the circuit structure 100 of Figure 1 is being used, the integrated circuit dies 110 may be kept within particular temperature operating limits, thus allowing for increased operating efficiency and decreased power losses.

In Figure 1, the common coupler layer 120 is illustrated as a dashed-line box, and the individual common couplers that may comprise the common coupler layer 120 are not illustrated. However, Figure 4 illustrates an example of the individual common couplers that may make up a common coupler layer, albeit in a circuit structure that has a different layout of die contacts and package contacts than Figure 1. Specifically, Figure 4 illustrates a top view (in the negative z-direction) of a circuit structure 400, which is another example of a circuit structure that may be contained within a package in accordance with the principles described herein. Figure 4 likewise also illustrates the coordinate system 101, but with the positive z-direction directed out of the page, and with the x-y plane being parallel to the plane of the page.

The circuit structure 400 includes four integrated circuit dies 410A through 410D, which may be referred to collectively as "integrated circuit dies 410", or as an "integrated circuit die layer 410". The integrated circuit dies 410 are illustrated in solid-line form.

On top of the integrated circuit die layer 410 is a common coupler layer that includes multiple common couplers that are illustrated in dotted-lined form to distinguish from the integrated circuit dies 410. Specifically, the common coupler layer includes a gate common coupler 420G, and a sense transistor source common coupler 420SS. In addition, the common coupler layer includes drain common coupler portions 420D that collectively act as a drain common coupler (also referred to as a "drain common coupler 420D"). Finally, the common coupler layer also includes power transistor source common coupler portions 420S that collectively acts as a power transistor source common coupler (also referred to as a "power transistor source common coupler 420S"). The combination of the gate common coupler 420G, the drain common coupler 420D, the power transistor source common coupler 420S, and the sense transistor source common coupler 420SS may be collectively referred to as a "common coupler layer 420".

On top of the common coupler layer 420 are multiple package contacts 430A through 430D (referred to collectively as "package contacts 430" or "package contact layer 430"). To distinguish from the other layers of the circuit structure 400, the package contacts 430 are illustrated in dashed-line form.

Each of the integrated circuit dies 410 includes top planar surfaces along which multiple die contacts are laid out. As an example, each of the integrated circuit dies 410 may include a power field-effect transistor and a sense field-effect transistor, connected together as described with respect to Figure 2. In this case, the die contacts may include drain die contacts 412D, power transistor source die contacts 412S, sense transistor source die contacts 412SS, and gate die contacts 412G. For purposes of simplicity, only the integrated circuit dies 410A and 410D are illustrated as having a sense transistor source die contact 412SS. This is because, since each of the integrated circuit dies 410 may be instances of each other, it may not be necessary to monitor the sense transistor of each of the integrated circuit dies 410 in order to detect parameters of their corresponding power transistors. However, in another example embodiment, each of the integrated circuit dies 410A through 410D may have a sense transistor source die contact 412SS. In either case, the principles described herein are not limited to the die contacts of the integrated circuit dies 410.

The package contact 430A of the circuit structure 400 may be a drain package contact 430A, the package contact 430B may be a power transistor source package contact 430B, the package contact 430C may be a sense transistor source package contact 430C, and the package contact 430D may be a gate package contact 430D. As a side note, the package contact 430B has a planar profile shape that substantially overlaps the planar profiles of each of the integrated circuit dies 410. This allows for easy electrical connection between the power transistor source contacts 412S and the power transistor source package contact 430B.

The common coupler layer 420 uses the four common coupler portions 420D to connect eight drain die contacts 412D to the drain package contact 430A, and uses seven source common coupler portions 420S to connect ten power transistor source die contacts 412S to the power transistor source package contact 430B. Further, the common coupler layer 420 uses the common coupler 420SS to connect two sense transistor source die contacts 412SS to the sense transistor source package contact 430C, and uses the common coupler 420G to connect the four gate die contacts 412G to the gate package contact 430D. The common coupler layer 420 includes many conductive vias 422 (only some of which being shown to avoid confusing Figure 4), which connect the various common couplers of the common coupler layer 420 to the corresponding die contacts 412 and the package contacts 430. Thus, the drain die contacts 412D are each electrically connected to the drain package contact 430A, the power transistor source die contacts 412S are each electrically connected to the power transistor source package contact 430B, the sense transistor source die contacts 412SS are electrically connected to the power transistor source package contact 430C, and the gate die contacts 412G are electrically connected to the gate package contact 430D.

As a side note, each of the gate die contacts 412G of any of the individual integrated circuit dies 410 are internally connected to each other. So, while the common coupler 420G is illustrated as only connecting with the inner four of the gate die contacts 412G, the common coupler layer 420 still effectively connects the gate package contact 430D to the each of the gate die contacts 412G of each of the integrated circuit dies 410. Similarly, the left-most common coupler layer portion 420S, and the right-most common coupler layer portion 420S are each illustrated as overlapping two respective gate die contacts 412G. However, there are no conductive vias 422 connecting those outer common coupler portions 420S to those outer gate die contacts 412G.

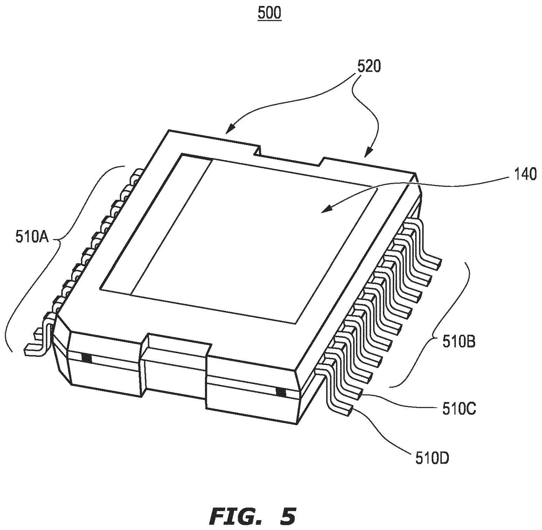

As previously expressed, the circuit structure 100 of Figure 1 may be incorporated into a package that includes leads that enable interaction between external devices and the integrated circuit dies 110 contained within the package. In this case, the leads may be attached to the package contacts 130, such that a portion of each of the leads protrudes from the package. Further, as previously expressed, when the circuit structure 100 is incorporated into a package by encasing the circuit structure 100 in an encapsulating component, a portion of the thermal layer 140 is exposed from outside of the package, allowing for temperature regulation of the integrated circuit dies 110. Figure 5 illustrates such a package, in which leads and a portion of a thermal layer protrude or are exposed from outside of the package.

Specifically, Figure 5 illustrates a package 500, which contains the circuit structure 100 of Figure 1, but with the circuit structure 100 of Figure 1 vertically flipped so that the thermal layer 140 is facing upwards. However, the principles described herein are not limited to the package 500 containing any particular circuit structure. The package 500 includes various groups of leads 510A through 510D (referred to collectively as "leads 510"), which may be attached to the package contacts 130 of Figure 1. The package 500 further includes an encapsulating component 520, from which portions of the leads 510 protrude, and from which the thermal layer 140 is exposed.

Recall the example of Figure 1 in which the package contact 130A is a drain package contact that is connected to the connected drain terminals of the power transistor and the sense transistor contained within the integrated circuit dies 110. In this case, the leads 510A may be drain leads that are attached to the drain package contact 130A of the circuit structure 100. Accordingly, an external device may apply a drain voltage to the connected drain terminals of the power transistor and the sense transistor via the leads 510A.

Further, recall the example in which the package contact 130B is a power transistor source package contact that is connected to the source terminal of only the power transistor. In this case, the leads 510B may be power transistor source leads that are attached to the power transistor source package contact 130B of the circuit structure 100. Accordingly, an external device may apply a power transistor source voltage to the source terminal of the power transistor via the leads 510B.

Also, recall the example in which the package contact 130C is a sense transistor source package contact that is connected to the source terminal of only the sense transistor. In this case, the lead 510C may be a sense transistor source lead that is attached to the sense transistor source package contact 130C of the circuit structure 100. Accordingly, an external device may apply a sense transistor source voltage to the source terminal of the sense transistor via the lead 510C.

Finally, recall the example in which the package contact 130D is a gate package contact that is connected to the connected gate terminals of the power transistor and the sense transistor. In this case, the lead 510D may be a gate lead that is attached to the gate package contact 130D of the circuit structure 100. Accordingly, an external device may apply a gate voltage to the connected gate terminals of the power transistor and the sense transistor via the lead 510D.

As previously expressed, a portion of the thermal layer 140 of the circuit structure 100 may remain exposed from the outside of the encapsulating component 520 of the package 500. Accordingly, this portion of the thermal layer 140 that remains exposed may be connected to a heatsink. Thus, when the package 500 is being used, heat generated by the integrated circuit dies 110 may be transferred to the heat sink via this thermal layer 140. Accordingly, the package 500 allows the integrated circuit dies 110 to be kept within particular temperature operating limits, thus allowing for increased operating efficiency and decreased power losses.

Further, as described with respect to Figure 1 and Figure 4, the common coupler layer of the circuit structure 100 of Figure 1 and the circuit structure 400 of Figure 4 may be customized with significant flexibility so as to electrically connect the die contacts of multiple integrated circuit dies to their corresponding package contacts, regardless of the conductive layouts of either of the die contacts and the package contacts. Therefore, the die contacts of the integrated circuit dies need not have the same layout as the package contacts. Thus, packages having the same package contact layout may be used to package various types of integrated circuit dies, and various numbers of integrated circuit dies, regardless of the layout of the die contacts of the integrated circuit dies. Furthermore, because the die contacts of the integrated circuit dies and the package contacts are in close proximity to each other, connected by conductive portions and conductive vias of the relatively thin routing layer, the overall package may be more compact, and may operate with high power density, low on-resistance, and low parasitic inductance.

As previously described, the embodiments described herein relate to a package in which multiple integrated circuit dies that each perform the same function are packaged in parallel such that all like die contacts are connected together and to a like package contact. Accordingly, the package as a whole performs the same function as each individual integrated circuit die. For instance, as mentioned above, if each of the integrated circuit dies includes a power transistor and a sense transistor as shown in Figure 2, then the package itself may also act as a larger version of the circuit that includes but a single larger power transistor (since smaller power transistors connected in parallel can be regarded as a single larger power transistor), and but a single larger sense transistor (since smaller sense transistors connected in parallel can be regarded as a single larger sense transistor). The reason why it is helpful to package multiple smaller integrated circuit dies into a package instead of using a single larger integrated circuit die will later be described after discussing some context.

Integrated circuit dies are fabricated with minute features using semiconductor processing technology. There is always some degree of variation in each processing step. When these variations are accumulated over many different processing steps required to manufacture an intricate circuit die, even integrated circuit dies intended to be identical can have significant performance differences. This problem is exacerbated when using brittle semiconductor materials, as cracks can appear in the structure at any point, and even small cracks can cause performance degradation.

For some types of variations, the larger the integrated circuit die, the larger then number of variations. Thus, by making a smaller version of the integrated circuit on a smaller integrated circuit die, there is less risk of introducing such variations. Accordingly, the percentage of useful integrated circuit dies may by higher for smaller die that for larger die. By selectively picking appropriate smaller integrated circuit dies and combining them into a larger integrated circuit, the net number of packages that can be constructed from a wafer-full of integrated circuit die may be larger if the wafer contained smaller integrated circuit die than larger integrated circuit die. Furthermore, packages of different performance levels may also be achieve by selecting appropriate integrated circuit die based on the measured performance of each integrated circuit die. For instance, highly performing integrated circuit dies may be selected for packaging into a high performance package, whereas moderate performing integrated circuit die may be selected for packing into a moderate performance package.

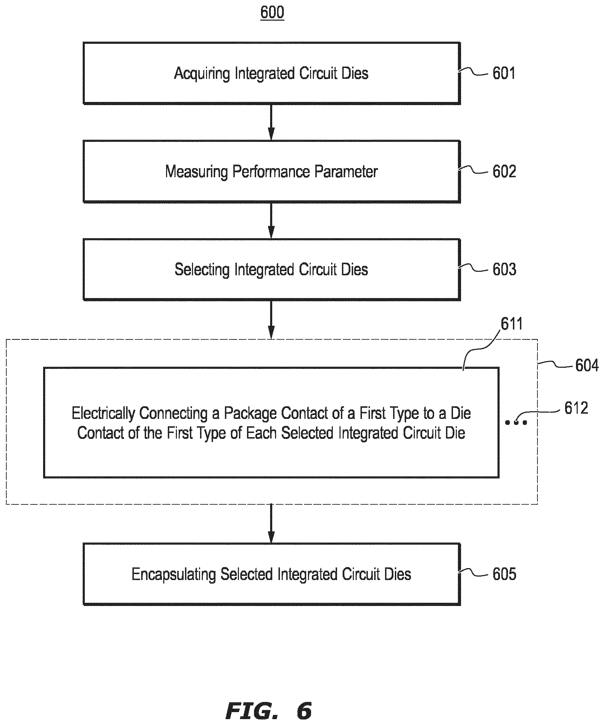

Figure 6 illustrates a flowchart of a method 600 for grouping integrated circuit dies into a package, in accordance with the principles described herein. First, a collection of integrated circuit dies is acquired (act 601), where each of the integrated circuit dies performs the same particular function. For example, suppose that each of the integrated circuit dies includes a power transistor and a sense transistor as described with respect to Figure 2. In this case, the function could be to provide power to the power transistor and the sense transistor contained within the integrated circuit die, where the source of the sense transistor is dependent on a parameter of the power transistor.

Next, each of the integrated circuit dies are tested and measured for one or more performance parameters (act 602) for performing the same particular function. For example, in the case where each integrated circuit contains a power transistor and a sense transistor as described with respect to Figure 2, the performance parameters could include the on-resistance, a current flow (such as the saturation current, the predicted aging of the power transistor contained therein, and so forth.

After the integrated circuit dies have been tested, some of the integrated circuit dies are selected and grouped based on their measured performance parameters (act 603). As an example, as previously expressed, the integrated circuit dies may be selected and organized into groups of four integrated circuit dies. However, the principles described herein are not limited to the particular number of integrated circuit dies per group.

At this point, like die contacts of the selected integrated circuit dies for any given group are then electrically connected to like package contacts of a package (act 604). That is, for a particular type of package contact, that package contact is electrically connected to die contacts of the same particular type (act 611). As represented by the ellipsis 612, this is done for multiple different types of contacts. As an example, suppose that each integrated circuit die in the group includes a gate die contact, a drain die contact, a power transistor source die contact, and a sense transistor source die contact. In this case, each of the gate die contacts of the integrated circuit dies of the group would be connected to a gate package contact of the package, each drain die contact would be connected to a drain package contact, each power transistor source die contact would be connected to a power transistor source package contact, and each sense transistor source die contact would be connected to a sense transistor source package contact. An example of how this might be done was described above with respect to Figure 4.

Finally, after connecting the like die contacts to the like package contacts, the integrated circuit dies are at least partially encapsulated in an encapsulation structure (act 605). As an example, the encapsulation structure may be the encapsulating component 520 of the package 500 of Figure 5. In this case, leads may be attached to the package contacts, and a portion of each of the leads and a thermal layer may be exposed from outside of the encapsulation structure.

Referring back to act 603, there are many different ways to select and group integrated circuit dies, based on many different performance parameters and performance standards for those performance parameters. For example, suppose that a package, containing a grouping of four integrated circuit dies, were to be constructed that had a very high standard for a specific performance parameter. In this case, four integrated circuit dies may be selected and grouped that were tested and measured to perform very well with respect to that performance parameter. Alternatively, suppose that a package was to be constructed that had only a moderate standard for the specific performance parameter. In this case, four integrated circuit dies may be selected and grouped that were tested and measured to perhaps perform moderately with respect to that performance parameter, even though the dies would not satisfy the higher performance standard.

As another non-limiting example, suppose instead that the goal was to mass-produce packages that each performed at an average standard for the performance parameter. In this case, integrated circuit dies could be selected and grouped in various ways to achieve this. For example, four integrated circuit dies that were tested and measured to perform averagely for the specific performance parameter could be combined into a group. Alternatively, a few integrated circuit dies that were tested and measured to perform very well with respect to the specific performance parameter could be combined with a few integrated circuit dies that were tested and measured to perform less well with respect to the specific performance parameter.

To give a specific example, suppose that the specific performance parameter is the on-resistance of a power transistor contained within the integrated circuit die. Suppose further that there is a first performance standard for a first package, and a second performance standard for a second package. Assume, for purposes of example only, that the first performance standard for the first package is that the total on-resistance of the first package should be within 10% of X (where X is a positive number representing a resistive value in ohms), and the second performance standard for the second package is that the total on-resistance for the second package should be within 20% of X.

Further, assume for example purposes only that there are ten total integrated circuit dies available for grouping into the first package and the second package, where each package includes a group of four integrated circuit dies connected in parallel. Suppose that each of the available integrated circuit dies varies significantly with respect to the on-resistance performance parameter.

For example, of the ten available integrated circuit dies, suppose that the ten integrated circuit die has resistive values as shown in Table 1 below.

**Table 1**

| Die Identifier | Resistive Value |
|---|---|
| 1 | 2X |
| 2 | 2.5X |
| 3 | 3X |
| 4 | 3.5X |
| 5 | 4X |
| 6 | 4.5X |
| 7 | 5X |
| 8 | 5.5X |
| 9 | 6X |
| 10 | 6.5 |

For each of the first package and the second package, there are many different ways that the available integrated circuit dies could be combined and connected in parallel so as to satisfy the first performance standard or the second performance standard. For example, dies 3, 5, 7 and 9 (having resistance 3X, 4X, 5X, 6X, respectively) could be connected in parallel to achieve a total package on-resistance of 1.053X. This would satisfy both the first performance standard for the first package (being within 10% of X) and the second performance standard for the second package (being within 20% of X). Thus, these integrated circuit dies could be used to form either the first package or the second package. However, for purposes of explanation, assume that dies 3, 5, 7 and 9 are used in the first package having the first performance standard of a total on-resistance of within 10% of X, and thus could not be used again to form a different instance of a package.

The remaining dies 1, 2, 4, 6, 8 and 10 (having respective resistances 2X, 2.5X, 3.5X, 4.5X, 5.5X, and 6.5X) could then also be combined in various ways to form packages. For example, the remaining dies 2, 4, 6 and 8 (having respective resistances 2.5X, 3.5X, 4.5X and 5.5X) could be connected in parallel to achieve a total package on-resistance of 0.918X, and thus would satisfy both the first and second performance standards, and could therefore be used either to form another instance of the first package, or to form an instance of the second package.

Alternatively, the remaining dies 4, 6, 8 and 10 (having resistances 3.5X, 4.5X, 5.5X and 6.5X) could be connected in parallel to achieve a total package on-resistance of 1.185X, which would only satisfy the seconded performance standard, and therefore could only be used to form an instance of the second package. As another alternative example, the remaining dies 1, 2, 8 and 10 (having resistances 2X, 2.5X, 5.5X and 6.5X) could be connected in parallel to achieve a total package on-resistance of 0.809X, which would also only satisfy the second performance standard, and therefore could only be used to form an instance of the second package.

Therefore, as seen from these examples, even for this one specific performance parameter of total package on-resistance, with only these two possible performance standards for packages, and with only a pool of ten different integrated circuit dies to select from, there are many different possible combinations of integrated circuit dies that may be used to form packages. The number of possible combinations is only increased when having a pool of hundreds or thousands of integrated circuit dies to choose from, and when having many different performance parameters (or combinations thereof) and standards for those performance parameters given for any particular package type.

Accordingly, by testing and measuring each of the plurality of integrated circuit dies, and then by grouping them as described, even integrated circuit dies that performed less well for any given performance parameter may still be incorporated into packages in some circumstances. Thus, by manufacturing and using groupings of smaller integrated circuit dies instead of a single larger integrated circuit die, packages may be constructed that have a wide variety of standards for specific performance parameters.

### Literal Support Section

Clause 1. A package configured to perform a function, the package comprising: a first integrated circuit die having a die contact of a first type and a die contact of a second type, the die contact of the first type of the first integrated circuit die and the die contact of the second type of first integrate circuit die each electrically connected to a first integrated circuit contained within the first integrated circuit die, the first integrated circuit structured to perform the function; a second integrated circuit die having a die contact of the first type and a die contact of the second type, the die contact of the first type of the second integrated circuit die and the die contact of the second type of second integrate circuit die each electrically connected to a second integrated circuit contained within the second integrated circuit die, the second integrated circuit structured to perform the function; a package contact of the first type; a package contact of the second type; a first common coupler that electrically connects the die contact of the first type of the first integrated circuit die and the die contact of the first type of the second integrated circuit die to the package contact of the first type; and a second common coupler that electrically connects the die contact of the second type of the first integrated circuit die and the die contact of the second type of the second integrated circuit die to the package contact of the second type.

Clause 2. The package according to Clause 1, the package further comprising: a package contact of a third type; and a third common coupler; the first integrated circuit die further having a die contact of the third type that is electrically connected to the first integrated circuit contained within the first integrated circuit die; the second integrated circuit die further having a die contact of the third type that is electrically connected to the second integrated circuit contained within the second integrated circuit die; the third common coupler electrically connecting the die contact of the third type of the first integrated circuit die and the die contact of the third type of the second integrated circuit die to the package contact of the third type.

Clause 3. The package according to Clause 2, the package further comprising: a package contact of a fourth type; and a fourth common coupler; the first integrated circuit die further having a die contact of the fourth type that is electrically connected to the first integrated circuit contained within the first integrated circuit die; the second integrated circuit die further having a die contact of the fourth type that is electrically connected to the second integrated circuit contained within the second integrated circuit die; the fourth common coupler electrically connecting the die contact of the fourth type of the first integrated circuit die and the die contact of the fourth type of the second integrated circuit die to the package contact of the fourth type.

Clause 4. The package according to Clause 3, the package further comprising: a third integrated circuit die having a die contact of the first type, a die contact of the second type, a die contact of the third type, and a die contact of the fourth type, the die contact of the first type of the third integrated circuit die, the die contact of the second type of third integrate circuit die, the die contact of the third type of the third integrated circuit die, and the die contact of the fourth type of the third integrated circuit die each electrically connected to a third integrated circuit contained within the third integrated circuit die, the third integrated circuit structured to perform the function; the first common coupler also electrically connecting the die contact of the first type of the third integrated circuit die to the package contact of the first type; the second common coupler also electrically connecting the die contact of the second type of the third integrated circuit die to the package contact of the second type; the third common coupler also electrically connecting the die contact of the third type of the third integrated circuit die to the package contact of the third type; and the fourth common coupler also electrically connecting the die contact of the fourth type of the third integrated circuit die to the package contact of the fourth type.

Clause 5. The package according to Clause 4, the package further comprising: a fourth integrated circuit die having a die contact of the first type, a die contact of the second type, a die contact of the third type, and a die contact of the fourth type, the die contact of the first type of the fourth integrated circuit die, the die contact of the second type of fourth integrate circuit die, the die contact of the third type of the fourth integrated circuit die, and the die contact of the fourth type of the fourth integrated circuit die each electrically connected to a fourth integrated circuit contained within the fourth integrated circuit die, the fourth integrated circuit structured to perform the function; the first common coupler also electrically connecting the die contact of the first type of the fourth integrated circuit die to the package contact of the first type; the second common coupler also electrically connecting the die contact of the second type of the fourth integrated circuit die to the package contact of the second type; the third common coupler electrically connecting the die contact of the third type of the fourth integrated circuit die to the package contact of the third type; and the fourth common coupler also electrically connecting the die contact of the fourth type of the fourth integrated circuit die to the package contact of the fourth type.

Clause 6. The package according to Clause 3, the first integrated circuit die and the second integrated circuit die together forming an integrated circuit die layer, the package contacts of the first type, the second type, the third type and the fourth type each forming a package contact layer, the first common coupler, the second common coupler, the third common coupler, and the fourth common coupler being between the integrated circuit die layer and the package contact layer.

Clause 7. The package according to Clause 3, the first integrated circuit comprising a first power field-effect transistor and a first sense field-effect transistor, and the second integrated circuit comprising a second power field-effect transistor and a second sense field-effect transistor.

Clause 8. The package according to Clause 7, the die contact of the first type of the first integrated circuit die being a first gate die contact that is electrically connected to a gate terminal of the first power field-effect transistor and a gate terminal of the first sense field-effect transistor; the die contact of the first type of the second integrated circuit die being a second gate die contact that is electrically connected to a gate terminal of the second power field-effect transistor and a gate terminal of the second sense field-effect transistor; the package contact of the first type being a gate package contact; the first common coupler being a gate common coupler that electrically connects the first gate die contact of the first integrated circuit die and the second gate die contact of the second integrated circuit die to the gate package contact.

Clause 9. The package according to Clause 8, the die contact of the second type of the first integrated circuit die being a first drain die contact that is electrically connected to a drain terminal of the first power field-effect transistor and a drain terminal of the first sense field-effect transistor; the die contact of the second type of the second integrated circuit die being a second drain die contact that is electrically connected to a drain terminal of the second power field-effect transistor and a drain terminal of the second sense field-effect transistor; the package contact of the second type being a drain package contact; the second common coupler being a drain common coupler that electrically connects the first drain die contact of the first integrated circuit die and the second drain die contact of the second integrated circuit die to the drain package contact.

Clause 10. The package according to Clause 9, the die contact of the third type of the first integrated circuit die being a first power transistor source die contact that is electrically connected to a source terminal of the first power field-effect transistor; the die contact of the third type of the second integrated circuit die being a second power transistor source die contact that is electrically connected to a source terminal of the second power field-effect transistor; the package contact of the third type being a power transistor source package contact; the third common coupler being a power transistor source common coupler that electrically connects the first power transistor source die contact of the first integrated circuit die and the second power transistor source die contact of the second integrated circuit die to the power transistor source package contact.

Clause 11. The package according to Clause 10, the die contact of the fourth type of the first integrated circuit die being a first sense transistor source die contact that is electrically connected to a source terminal of the first sense field-effect transistor; the die contact of the fourth type of the second integrated circuit die being a second sense transistor source die contact that is electrically connected to a source terminal of the second sense field-effect transistor; the package contact of the fourth type being a sense transistor source package contact; the fourth common coupler being a sense transistor source common coupler that electrically connects the first sense transistor source die contact of the first integrated circuit die and the second sense transistor source die contact of the second integrated circuit die to the sense transistor source package contact.

Clause 12. A method for manufacturing a package that performs a function and that contains multiple integrated circuit dies; acquiring a plurality of integrated circuit dies; measuring a performance parameter for each of at least some of the plurality of integrated circuit dies; based on the measured performance parameter, selecting a first integrated circuit die and a second integrated circuit die, the first integrated circuit die having a die contact of a first type and a die contact of a second type, the die contact of the first type of the first integrated circuit die and the die contact of the second type of first integrate circuit die each electrically connected to a first integrated circuit contained within the first integrated circuit die, the first integrated circuit structured to perform the function, the second integrated circuit die having a die contact of the first type and a die contact of the second type, the die contact of the first type of the second integrated circuit die and the die contact of the second type of second integrate circuit die each electrically connected to a second integrated circuit contained within the second integrated circuit die, the second integrated circuit structured to perform the function; electrically connecting a package contact of the first type through a first common coupler to the die contact of the first type of the first integrated circuit die and the die contact of the first type of the second integrated circuit die; electrically connecting a package contact of the second type through a second common coupler to the die contact of the second type of the first integrated circuit die and the die contact of the second type of the second integrated circuit die; and at least partially encapsulating the first integrated circuit die and the second integrated circuit die. and a second common coupler that electrically connects the die contact of the second type of the first integrated circuit die and the die contact of the second type of the second integrated circuit die to the package contact of the second type.

Although the subject matter has been described in language specific to structural features and/or methodological acts, it is to be understood that the subject matter defined in the appended claims is not necessarily limited to the described features or acts described above, or the order of the acts described above. Rather, the described features and acts are disclosed as example forms of implementing the claims.

The present disclosure may be embodied in other specific forms without departing from its essential characteristics. The described embodiments are to be considered in all respects only as illustrative and not restrictive. All changes which come within the meaning and range of equivalency of the claims are to be embraced within their scope.

When introducing elements in the appended claims, the articles "a," "an," "the," and "said" are intended to mean there are one or more of the elements. The terms "comprising," "including," and "having" are intended to be inclusive and mean that there may be additional elements other than the listed elements.

## Claims

1. A package configured to perform a function, the package comprising:
a first integrated circuit die having a die contact of a first type and a die contact of a second type, the die contact of the first type of the first integrated circuit die and the die contact of the second type of first integrate circuit die each electrically connected to a first integrated circuit contained within the first integrated circuit die, the first integrated circuit structured to perform the function;
a second integrated circuit die having a die contact of the first type and a die contact of the second type, the die contact of the first type of the second integrated circuit die and the die contact of the second type of second integrate circuit die each electrically connected to a second integrated circuit contained within the second integrated circuit die, the second integrated circuit structured to perform the function;
a package contact of the first type;
a package contact of the second type;
a first common coupler that electrically connects the die contact of the first type of the first integrated circuit die and the die contact of the first type of the second integrated circuit die to the package contact of the first type; and
a second common coupler that electrically connects the die contact of the second type of the first integrated circuit die and the die contact of the second type of the second integrated circuit die to the package contact of the second type.

2. The package according to Claim 1, the package further comprising:
a package contact of a third type; and
a third common coupler;
the first integrated circuit die further having a die contact of the third type that is electrically connected to the first integrated circuit contained within the first integrated circuit die;
the second integrated circuit die further having a die contact of the third type that is electrically connected to the second integrated circuit contained within the second integrated circuit die;
the third common coupler electrically connecting the die contact of the third type of the first integrated circuit die and the die contact of the third type of the second integrated circuit die to the package contact of the third type.

3. The package according to Claim 2, the package further comprising:
a package contact of a fourth type; and
a fourth common coupler;
the first integrated circuit die further having a die contact of the fourth type that is electrically connected to the first integrated circuit contained within the first integrated circuit die;
the second integrated circuit die further having a die contact of the fourth type that is electrically connected to the second integrated circuit contained within the second integrated circuit die;
the fourth common coupler electrically connecting the die contact of the fourth type of the first integrated circuit die and the die contact of the fourth type of the second integrated circuit die to the package contact of the fourth type.

4. The package according to Claim 3, the package further comprising:
a third integrated circuit die having a die contact of the first type, a die contact of the second type, a die contact of the third type, and a die contact of the fourth type,
the die contact of the first type of the third integrated circuit die, the die contact of the second type of third integrate circuit die, the die contact of the third type of the third integrated circuit die, and the die contact of the fourth type of the third integrated circuit die each electrically connected to a third integrated circuit contained within the third integrated circuit die, the third integrated circuit structured to perform the function;
the first common coupler also electrically connecting the die contact of the first type of the third integrated circuit die to the package contact of the first type;
the second common coupler also electrically connecting the die contact of the second type of the third integrated circuit die to the package contact of the second type;
the third common coupler also electrically connecting the die contact of the third type of the third integrated circuit die to the package contact of the third type; and
the fourth common coupler also electrically connecting the die contact of the fourth type of the third integrated circuit die to the package contact of the fourth type.

5. The package according to Claim 4, the package further comprising:
a fourth integrated circuit die having a die contact of the first type, a die contact of the second type, a die contact of the third type, and a die contact of the fourth type,
the die contact of the first type of the fourth integrated circuit die, the die contact of the second type of fourth integrate circuit die, the die contact of the third type of the fourth integrated circuit die, and the die contact of the fourth type of the fourth integrated circuit die each electrically connected to a fourth integrated circuit contained within the fourth integrated circuit die, the fourth integrated circuit structured to perform the function;
the first common coupler also electrically connecting the die contact of the first type of the fourth integrated circuit die to the package contact of the first type;
the second common coupler also electrically connecting the die contact of the second type of the fourth integrated circuit die to the package contact of the second type;
the third common coupler electrically connecting the die contact of the third type of the fourth integrated circuit die to the package contact of the third type; and
the fourth common coupler also electrically connecting the die contact of the fourth type of the fourth integrated circuit die to the package contact of the fourth type.

6. The package according to any one of Claims 3 to 5,
the first integrated circuit die and the second integrated circuit die together forming an integrated circuit die layer,
the package contacts of the first type, the second type, the third type and the fourth type each forming a package contact layer,
the first common coupler, the second common coupler, the third common coupler, and the fourth common coupler being between the integrated circuit die layer and the package contact layer.

7. The package according to any one of Claims 3 to 6,
the first integrated circuit comprising a first power field-effect transistor and a first sense field-effect transistor, and the second integrated circuit comprising a second power field-effect transistor and a second sense field-effect transistor.

8. The package according to Claim 7,
the die contact of the first type of the first integrated circuit die being a first gate die contact that is electrically connected to a gate terminal of the first power field-effect transistor and a gate terminal of the first sense field-effect transistor;
the die contact of the first type of the second integrated circuit die being a second gate die contact that is electrically connected to a gate terminal of the second power field-effect transistor and a gate terminal of the second sense field-effect transistor;
the package contact of the first type being a gate package contact;
the first common coupler being a gate common coupler that electrically connects the first gate die contact of the first integrated circuit die and the second gate die contact of the second integrated circuit die to the gate package contact.

9. The package according to Claim 8,
the die contact of the second type of the first integrated circuit die being a first drain die contact that is electrically connected to a drain terminal of the first power field-effect transistor and a drain terminal of the first sense field-effect transistor;
the die contact of the second type of the second integrated circuit die being a second drain die contact that is electrically connected to a drain terminal of the second power field-effect transistor and a drain terminal of the second sense field-effect transistor;
the package contact of the second type being a drain package contact;
the second common coupler being a drain common coupler that electrically connects the first drain die contact of the first integrated circuit die and the second drain die contact of the second integrated circuit die to the drain package contact.

10. The package according to Claim 9,
the die contact of the third type of the first integrated circuit die being a first power transistor source die contact that is electrically connected to a source terminal of the first power field-effect transistor;
the die contact of the third type of the second integrated circuit die being a second power transistor source die contact that is electrically connected to a source terminal of the second power field-effect transistor;
the package contact of the third type being a power transistor source package contact;
the third common coupler being a power transistor source common coupler that electrically connects the first power transistor source die contact of the first integrated circuit die and the second power transistor source die contact of the second integrated circuit die to the power transistor source package contact.

11. The package according to Claim 10,
the die contact of the fourth type of the first integrated circuit die being a first sense transistor source die contact that is electrically connected to a source terminal of the first sense field-effect transistor;
the die contact of the fourth type of the second integrated circuit die being a second sense transistor source die contact that is electrically connected to a source terminal of the second sense field-effect transistor;
the package contact of the fourth type being a sense transistor source package contact;
the fourth common coupler being a sense transistor source common coupler that electrically connects the first sense transistor source die contact of the first integrated circuit die and the second sense transistor source die contact of the second integrated circuit die to the sense transistor source package contact.

12. A method for manufacturing a package that performs a function and that contains multiple integrated circuit dies;
acquiring a plurality of integrated circuit dies;
measuring a performance parameter for each of at least some of the plurality of integrated circuit dies;
based on the measured performance parameter, selecting a first integrated circuit die and a second integrated circuit die, the first integrated circuit die having a die contact of a first type and a die contact of a second type, the die contact of the first type of the first integrated circuit die and the die contact of the second type of first integrate circuit die each electrically connected to a first integrated circuit contained within the first integrated circuit die, the first integrated circuit structured to perform the function, the second integrated circuit die having a die contact of the first type and a die contact of the second type, the die contact of the first type of the second integrated circuit die and the die contact of the second type of second integrate circuit die each electrically connected to a second integrated circuit contained within the second integrated circuit die, the second integrated circuit structured to perform the function;
electrically connecting a package contact of the first type through a first common coupler to the die contact of the first type of the first integrated circuit die and the die contact of the first type of the second integrated circuit die;
electrically connecting a package contact of the second type through a second common coupler to the die contact of the second type of the first integrated circuit die and the die contact of the second type of the second integrated circuit die; and
at least partially encapsulating the first integrated circuit die and the second integrated circuit die.

13. The method according to claim 12, wherein the method is adapted for manufacturing the package of any one of claims 1 to 11.
